# EUROPÄISCHE PATENTSCHRIFT

(11) **EP 4 471 439 B1**
(45) Veröffentlichungstag und Bekanntmachung des Hinweises auf die Patenterteilung: **04.02.2026**
(21) Anmeldenummer: 24174533.0
(22) Anmeldetag: 07.05.2024
(51) Int. Cl.: G01R 27/02, B60L 3/00, G01R 31/00, G01R 31/54

(54) **ENERGIEVERSORGUNGSVORRICHTUNG, FAHRZEUG SOWIE VERFAHREN ZUR ÜBERWACHUNG EINES KONTAKTVERLUSTS EINER MESSLEITUNG**
ENERGY SUPPLY DEVICE, VEHICLE AND METHOD FOR MONITORING A LOSS OF CONTACT OF A MEASURING LINE
DISPOSITIF D'ALIMENTATION ÉLECTRIQUE, VÉHICULE ET PROCÉDÉ DE SURVEILLANCE D'UNE PERTE DE CONTACT D'UNE LIGNE DE MESURE

(30) Priorität: 31.05.2023 DE 102023205081
(43) Veröffentlichungstag der Anmeldung: 04.12.2024
(73) Patentinhaber: Siemens Mobility GmbH, 80997 München (DE)
(72) Erfinder: Stark, Thomas, 15569 Woltersdorf (DE); Sänger, Göran, 12587 Berlin (DE)
(74) Vertreter: Siemens Patent Attorneys

(56) Entgegenhaltungen:
- EP-B1- 1 759 913
- US-B2- 10 632 855
- US-B2- 9 024 769

## Beschreibung

Die Erfindung betrifft eine Energieversorgungsvorrichtung, ein Fahrzeug sowie ein Verfahren zur Überwachung eines Kontaktverlusts einer Messleitung.

Elektrisch betriebene Straßenfahrzeuge sind in der Regel durch eine Gummibereifung gegenüber einem Untergrund elektrisch isoliert. Daher werden üblicherweise metallische Bestandteile des Straßenfahrzeugs als Masse vorgesehen. Beispielsweise kann ein Fahrzeuggehäuse oder ein Fahrgestell des Straßenfahrzeugs als Masse vorgesehen sein. Im Fehlerfall kann dies jedoch dazu führen, dass die genannten metallischen Bestandteile des Straßenfahrzeugs mit elektrischer Energie beaufschlagt werden. Dies birgt insbesondere für einen Benutzer des Straßenfahrzeugs ein erhebliches Gefahrenpotential. Aus Sicherheitsgründen ist es daher erforderlich, stets einen Isolationswiderstand zu überwachen. Zu diesem Zweck sind dem Fachmann bereits verschiedene Messmittel und Messmethoden bekannt. Um eine hohe Zuverlässigkeit bei der Isolationsüberwachung gewährleisten zu können, werden diese Messmittel als solche selbst überwacht. Zumeist erfolgt die Überwachung der Messmittel durch eine übergeordnete Steuerungsvorrichtung. Dadurch können Defekte an den Messmitteln erkannt werden. Alternativ oder zusätzlich besteht die Möglichkeit, dass sich ein betreffendes Messmittel anhand einer Selbstdiagnose überwacht. Bei einem besonders relevanten Defekt handelt es sich beispielsweise um einen Kontaktverlust einer zugehörigen Messleitung. Um diesen Defekt zu erkennen, ist es bereits bekannt, dass mittels der Messleitungen eine Potentialdifferenz zwischen Anschlüssen einer Energiequelle überwacht wird. Dadurch kann bereits im Rahmen der Selbstdiagnose rasch und zuverlässig ein Kontaktverlust einer Messleitung erkannt werden.

Um zu verhindern, dass im Fehlerfall eine Gefahr durch als die vorgenannte Masse vorgesehene metallische Bauteile ausgeht, kann eine sogenannte Zwischenmasse vorgesehen werden. Insbesondere wird eine Zwischenmasse im Falle eines Betriebs von Straßenfahrzeugen mittels einer elektrischen Oberleitung vorgesehen. Üblicherweise sind Zwischenmassen als Referenzmassen ausgeführt. Zweckmäßigerweise ist die Referenzmasse abhängig von einer Stromversorgung eines Isolationsüberwachungsgerätes. Eine Masse und eine Zwischenmasse weisen in der Regel den gleichen Massebezug auf. In alternativen Anwendungsfällen ist auch die umgekehrte Anordnung denkbar. Zum Zwecke einer Gewährleistung einer elektrischen Sicherheit wird die Zwischenmasse üblicherweise ist elektrisch von den als Masse vorgesehenen metallischen Bauteilen isoliert. Problematisch dabei ist jedoch, dass ein Defekt an Messmitteln nicht mittels der oben beschriebenen Vorgehensweise erkannt werden kann. Daher werden in diesem speziellen Anwendungsfall ein Isolationswiderstand zwischen den elektrischen Anschlüssen der Energiequelle und der Zwischenmasse sowie ein Isolationswiderstand zwischen der Zwischenmasse und der weiteren Masse jeweils eigenständig überwacht. Im Falle der Überwachung des Isolationswiderstands zwischen der Zwischenmasse und der weiteren Masse können die Anschlüsse der Energiequelle jedoch nicht zum Zwecke der Überwachung eines Kontaktverlusts der zugehörigen Messleitungen herangezogen werden

EP 1 759 913 B1 und US 10 632 855 B2 offenbaren Energieversorgungsvorrichtungen gemäß der Präambel des Anspruchs 1.

Aufgabe der Erfindung ist es, eine zuverlässige Überwachung von Isolationswiderständen zu ermöglichen.

Diese Aufgabe wird gelöst durch eine Energieversorgungsvorrichtung gemäß den Merkmalen des Anspruchs 1. Zudem wird diese Aufgabe gelöst durch ein Fahrzeug gemäß den Merkmalen des nebengeordneten gegenständlichen Anspruchs. Des Weiteren wird diese Aufgabe gelöst durch ein Verfahren mit den Merkmalen des nebengeordneten Verfahrensanspruchs.

Vorteilhafte Weiterbildungen sind jeweils Gegenstand abhängiger Unteransprüche.

Die erfindungsgemäße Energieversorgungsvorrichtung weist eine Anschlussvorrichtung zum Zwecke einer elektrischen Verbindung der Energieversorgungsvorrichtung mit einer Energiequelle erster Art auf. Des Weiteren weist die Energieversorgungsvorrichtung eine Masse erster Art sowie eine Masse zweiter Art auf. Unter einer Masse soll im vorliegenden Zusammenhang eine Masse im Sinne der Elektrotechnik verstanden werden. In der Regel handelt es sich bei der Masse im Sinne der Elektrotechnik um einen elektrisch leitenden Körper, welchem ein Bezugspotential zugeordnet wird. Vorzugsweise ist als Masse erster Art eine Zwischenmasse vorgesehen. Beispielhaft können als Masse zweiter Art ein Fahrgestell und/oder ein Fahrzeuggehäuse vorgesehen sein.

Zudem weist die erfindungsgemäße Energieversorgungsvorrichtung ein erstes Messgerät auf, welches dazu eingerichtet ist, einen Isolationswiderstand zwischen der genannten Anschlussvorrichtung und der Masse erster Art zu überwachen. Des Weiteren ist ein weiteres Messgerät vorgesehen, welches dazu eingerichtet ist, einen Isolationswiderstand zwischen der Masse erster Art und der Masse zweiter Art zu überwachen. Bei den genannten Messgeräten handelt es sich um dem Fachmann bereits bekannte Messgeräte zum Zwecke einer Messung sowie einer Überwachung eines Isolationswiderstands. Bevorzugt weisen die genannten Messgeräte jeweils eine Kommunikationsschnittstelle auf. Bevorzugterweise handelt es sich bei der Kommunikationsschnittstelle um eine Bus-Schnittstelle, wie beispielsweise eine CAN-Bus-Schnittstelle. Unter der CAN-Bus-Schnittstelle soll dabei ein serielles Bussystem verstanden werden, welches den Feldbussen untergeordnet ist. Dabei steht CAN als Akronym für "Controller-Area-Network".

Das weitere Messgerät der erfindungsgemäßen Energieversorgungsvorrichtung weist mehrere Messleitungen auf. Von diesen mehreren Messleitungen ist eine erste Messleitung elektrisch mit einem ersten Potential einer Energiequelle zweiter Art verbunden. Des Weiteren ist eine weitere Messleitung der mehreren Messleitungen mit der Masse zweiter Art verbunden.

Mittels einer Messung und Überwachung einer Potentialdifferenz zwischen der ersten Messleitung und der weiteren Messleitung kann auf eine einfache Weise ein Zustand der beiden Messleitungen überwacht werden. So kann ein Kontaktverlust der zu überwachenden Messleitungen rasch und zuverlässig erkannt werden. Insbesondere kann auf diese Weise ein Bruch der zu überwachenden Messleitung erkannt werden. Ein bislang im Zusammenhang mit einer Messung eines Isolationswiderstands zwischen einer Masse erster Art und einer Masse zweiter Art nicht diagnostizierbarer Defekt wird damit zuverlässig erkennbar.

Eine vorteilhafte Weiterbildung sieht vor, dass als Energiequelle erster Art eine Hochvolt-Energiequelle vorgesehen ist. Dabei soll die Hochvolt-Energiequelle im vorliegenden Zusammenhang im Sinne der Fahrzeugtechnik verstanden werden. In der Regel ist als Betriebsspannung einer solchen Hochvolt-Energiequelle eine Wechselspannung größer 30 V oder eine Gleichspannung größer 60 V vorgesehen. Auf diese Weise kann eine Energieversorgungsvorrichtung bereitgestellt werden, mittels welcher betriebssicher elektrische Energie zum Zwecke eines Antriebs eines Fahrzeugs und/oder zum Zwecke eines Aufladens eines Hochvoltenergiespeichers aus einer Hochvolt-Energiequelle hin zu einer zugehörigen Antriebsvorrichtung und/oder Hochvoltenergiespeicher geleitet werden kann. Insbesondere ist auf diese Weise ein Laden des Hochvoltenergiespeichers während einer Fahrt des Fahrzeugs möglich. Dieses Verfahren ist mithin bekannt unter der Bezeichnung "dynamisches Laden". Dadurch kann elektrische Energie für Streckenabschnitte ohne eine äußere Hochvolt-Energiequelle gespeichert werden.

Eine weitere vorteilhafte Weiterbildung sieht vor, dass als Energiequelle zweiter Art eine Niedervolt-Energiequelle vorgesehen ist. Die Niedervolt-Energiequelle soll im vorliegenden Zusammenhang im Sinne der Fahrzeugtechnik verstanden werden. In der Regel ist bei einer solchen Niedervolt-Energiequelle als Betriebsspannung eine Wechselspannung kleiner oder gleich 30 V oder eine Gleichspannung kleiner oder gleich 60 V vorgesehen. Eine Überwachung der Messleitungen im Hinblick auf einen Kontaktverlust kann auf diese Weise energiesparend und einfach technisch realisierbar bereitgestellt werden.

Ferner wird in einer vorteilhaften Weiterbildung vorgeschlagen, dass ein erstes Potential der Energiequelle zweiter Art galvanisch mit einem zweiten Potential dieser Energiequelle zweiter Art verbunden ist. Dies ermöglicht es, eine vordefinierte Potentialdifferenz zum Zwecke einer Überwachung einer Betriebsfähigkeit der betrachteten Messleitungen zu nutzen.

Vorzugsweise ist als die vorgenannte Anschlussvorrichtung ein Stromabnehmer vorgesehen. Unter dem Stromabnehmer soll im vorliegenden Zusammenhang eine Vorrichtung verstanden werden, mittels welcher elektrische Energie von einem entlang einer vorbestimmten Strecke angeordneten stromführenden Leiter in die Energieversorgungsvorrichtung einspeisbar ist. Zweckmäßigerweise handelt es sich bei dem Stromabnehmer um einen dem Fachmann bereits bekannten sogenannten Pantographen. Auf diese Weise kann eine flexibel einsetzbare Energieversorgungsvorrichtung bereitgestellt werden. Des Weiteren kann dadurch eine mobile Energieversorgungsvorrichtung realisiert werden.

Ferner ist in einer vorteilhaften Weiterbildung vorgesehen, dass die weitere Messleitung durch eine elektrisch leitende Verbindung mit dem zweiten Potential der vorgenannten Energiequelle zweiter Art mit der Masse zweiter Art verbunden ist. Dies ermöglicht eine präzise Messung einer Potentialdifferenz zwischen dem ersten Potential der Energiequelle zweiter Art und der Masse zweiter Art. Eine Zuverlässigkeit der Überwachung im Hinblick auf einen Kontaktverlust der weiteren Messung zu der Masse zweiter Art kann auf diese Weise gesteigert werden.

Das erfindungsgemäße Fahrzeug weist die erfindungsgemäße Energieversorgungsvorrichtung auf. Des Weiteren weist das erfindungsgemäße Fahrzeug eine elektrische Antriebsvorrichtung auf, welche mittels der erfindungsgemäßen Energieversorgungsvorrichtung betreibbar ist. Auf diese Weise kann ein sicher betreibbares Fahrzeug bereitgestellt werden. Gefahren, welche von stromführenden Fahrzeugteilen oder mittels elektrischer Energie aufgeladenen Fahrzeugteilen ausgehen, können dadurch verringert werden.

In einer vorteilhaften Weiterbildung des Fahrzeugs ist vorgesehen, dass die genannte Energieversorgungsvorrichtung Teil eines Straßenfahrzeugs ist. In der Regel weisen solche Fahrzeuge ein isoliertes Bordnetz auf. Dabei ist eine elektrische Sicherheit grundsätzlich durch eine Trennung einer Hochvoltenergieversorgung von einem Bordnetz des Fahrzeugs getrennt ausgeführt. Zwar ist eine solche Trennung üblicherweise einfehlersicher ausgeführt. Ist jedoch die Isolierung an mehreren Stellen durchlässig zu einer Karosserie - und sei es nur für relativ geringe (Kriech-)Ströme aufgrund poröser Isolierungen und/oder Feuchtigkeit -, dann kann ein geschlossener Stromkreis über die Karosserie entstehen. In diesem Gefahrenfall können elektrische Stromschläge die Folge sein. Eine wirksame Trennung kann mittels der vorliegenden Energieversorgungsvorrichtung auf eine sichere und zuverlässige Weise überwacht werden. Daher kann eine Betriebssicherheit von elektrisch betriebenen Straßenfahrzeugen erheblich gesteigert werden.

Ferner sieht eine vorteilhafte Weiterbildung des Fahrzeugs vor, dass als die Energiequelle zweiter Art eine Starterbatterie des Fahrzeugs vorgesehen ist. Unter der Starterbatterie soll im vorliegenden Zusammenhang eine Energiequelle des Fahrzeugs verstanden werden, mittels welcher eine elektronische Energie für einen Anlasser eines Verbrennungsmotors, für einen Betrieb von Nebenaggregaten und/oder Steuerungskomponenten des Fahrzeugs bereitgestellt wird. Dieser Verbrennungsmotor kann beispielsweise zum Zwecke eines Antriebs des Fahrzeugs vorgesehen sein oder als Nebenantriebsaggregat. Eine bereits vorhandene Starterbatterie des Fahrzeugs kann auf diese Weise genutzt werden, um einen Kontaktverlust einer Messleitung des weiteren Messgeräts zu überwachen. Damit kann eine Steigerung des Gewichts des Fahrzeugs vermieden werden.

Zudem sieht die Erfindung ein Verfahren zur Überwachung eines Kontaktverlusts einer Messleitung der mehreren Messleitungen des weiteren Messgeräts der erfindungsgemäßen Energieversorgungsvorrichtung vor.

Bei dem erfindungsgemäßen Verfahren wird mittels der zu überwachenden Messleitung ein Ist-Wert einer Potentialdifferenz zwischen einem ersten Potential und einem zweiten Potential der Energiequelle zweiter Art der erfindungsgemäßen Energieversorgungsvorrichtung erfasst. Auf diese Weise kann eine besonders zuverlässige Überwachung der betrachteten Messleitung im Hinblick auf einen Kontaktverlust bereitgestellt werden. Ein Isolationswiderstand zwischen der Masse erster Art und der Masse zweiter Art kann auf diese Weise sicher und zuverlässig überwacht werden.

Eine vorteilhafte Weiterbildung des Verfahrens sieht vor, dass der Ist-Wert der Potentialdifferenz zwischen dem ersten Potential und dem zweiten Potential der Energiequelle zweiter Art mittels des weiteren Messgeräts ermittelt wird. Auf Zusatzbauteile, welche üblicherweise selbst einem Überwachungserfordernis im Hinblick auf eine Betriebssicherheit unterliegen, kann verzichtet werden.

Eine weitere vorteilhafte Weiterbildung des Verfahrens sieht vor, dass mittels des weiteren Messgeräts ein Wert betreffend eine Abweichung des ermittelten Ist-Werts der Potentialdifferenz von einem vorgebbaren Soll-Wert der Potentialdifferenz ermittelt wird. Insbesondere betrifft der Soll-Wert einen Soll-Wertebereich der Potentialdifferenz. Vorzugsweise wird daraufhin eine Information betreffend die genannte Abweichung ausgegeben, sobald der ermittelte Wert von einem vorgegebenen Bezugswert abweicht. Im Rahmen einer Selbstdiagnose kann mittels des weiteren Messgeräts ein Kontaktverlust der zu überwachenden Messleitung einfach und rasch festgestellt werden. Ferner kann auf diese Weise eine Warnung oder ein Steuerbefehl zum Zwecke einer Verhinderung einer Gefahr durch elektrisch leitende Bauteile oder elektrisch aufgeladene Bauteile ausgegeben werden. Auf Basis der genannten Information kann sodann eine Steuervorrichtung weitere Maßnahmen zur Abwendung von Gefahren für einen Nutzer des Fahrzeugs einleiten.

In einer anderen vorteilhaften Weiterbildung des Verfahrens wird als Energiequelle zweiter Art eine Starterbatterie eines Straßenfahrzeugs vorgesehen. Dabei ist vorgesehen, dass mittels der zu überwachenden Messleitung des weiteren Messgeräts ein Ist-Wert einer Potentialdifferenz der Starterbatterie erfasst wird. Dies ermöglicht es, auf einfache Weise eine Betriebssicherheit von Straßenfahrzeugen zu steigern. Die Gefahr von elektrisch bedingten Verletzungen eines Nutzers infolge einer Berührung von elektrisch aufgeladenen Fahrzeugteilen, kann auf diese Weise verringert werden.

Ferner sieht eine vorteilhafte Weiterbildung des Verfahrens vor, dass mittels des weiteren Messgeräts ein Isolationswiderstand zwischen der Masse erster Art und der Masse zweiter Art der genannten Energieversorgungsvorrichtung erfasst wird. Dies ermöglicht es, elektrische Gefahren, welche von einem herabgesetzten Isolationswiderstand herrühren, zuverlässig zu erkennen.

Vorzugsweise wird mittels der zu überwachenden Messleitung des weiteren Messgeräts der Isolationswiderstand zwischen der Masse erster Art und der Masse zweiter Art der genannten Energieversorgungsvorrichtung erfasst. Ein bislang im Rahmen der Selbstdiagnose nicht detektierbarer Kontaktverlust einer Messleitung, beispielsweise durch einen Bruch derselben, ist auf diese Weise zuverlässig feststellbar.

Die voranstehend beschriebenen Eigenschaften, Merkmale und Vorteile der Erfindung sowie die Art und Weise, wie diese erreicht werden, werden im Zusammenhang mit der nachfolgenden Figurenbeschreibung näher erläutert. Soweit zweckdienlich, werden in den Figuren dieselben Bezugszeichen für dieselben oder einander entsprechende Elemente der Erfindung verwendet. Die Ausführungsbeispiele dienen der Erläuterung der Erfindung und beschränken die Erfindung nicht auf die darin angegebenen Kombinationen von Merkmalen, auch nicht in Bezug auf funktionale Merkmale.

Es zeigen:
- FIG 1: ein Ausführungsbeispiel einer erfindungsgemäßen Energieversorgungsvorrichtung in einer schematischen Darstellung sowie eine Illustration eines Beispiels des erfindungsgemäßen Verfahrens;
- FIG 2: eine schematische Darstellung eines Ausführungsbeispiels eines erfindungsgemäßen, elektrisch betreibbaren Fahrzeugs;
- FIG 3: eine Illustration des Beispiels des erfindungsgemäßen Verfahrens anhand eines schematischen Ablaufdiagramms.

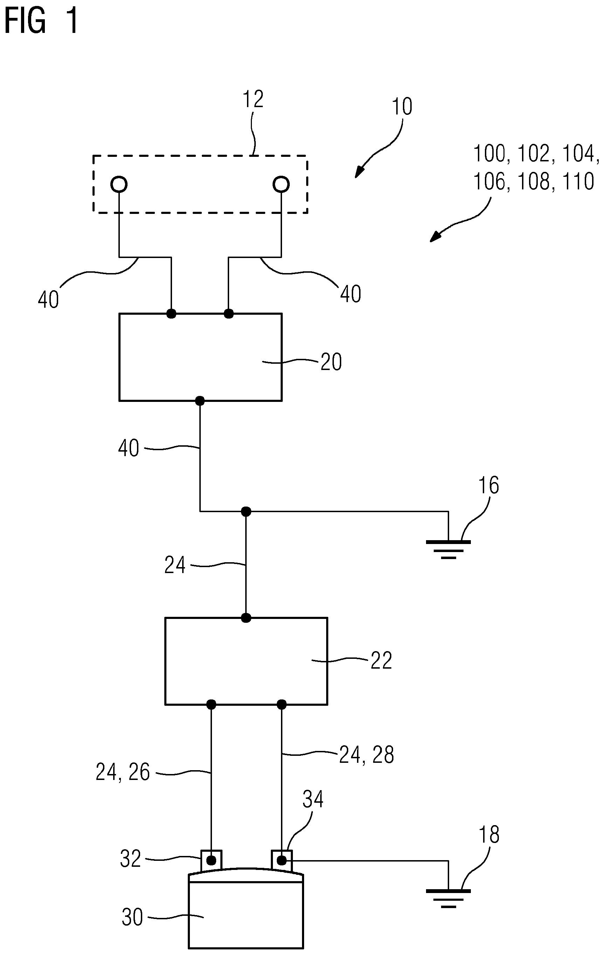

FIG 1 zeigt ein Ausführungsbeispiel einer Energieversorgungsvorrichtung 10 in einer schematischen Darstellung. Des Weiteren illustriert FIG 1 ein Beispiel eines Verfahrens 100 zur Überwachung eines Kontaktverlusts einer Messleitung (24, 26, 28).

Das in FIG 1 gezeigte Ausführungsbeispiel der Energieversorgungsvorrichtung 10 ist dazu eingerichtet, eine elektrische Energie von einer Energiequelle erster Art 14 hin zu einem zunächst nicht näher dargestellten Verbraucher zu leiten. Zum Zwecke einer elektrischen Verbindung der Energieversorgungsvorrichtung 10 mit der Energiequelle erster Art 14 ist eine Anschlussvorrichtung 12 vorgesehen. Vorzugsweise ist die Anschlussvorrichtung 12 dazu eingerichtet, elektrische Energie aus einer Hochvolt-Energiequelle zu beziehen.

Bei der Energieversorgungsvorrichtung 10 sind im vorliegenden Ausführungsbeispiel sowohl eine Masse erster Art 16 als auch eine Masse zweiter Art 18 vorgesehen. Die Masse erster Art 16 ist dabei elektrisch von der Masse zweiter Art 18 getrennt ausgeführt. Zudem ist die Masse erster Art 16 als Referenzmasse der Energieversorgungsvorrichtung 10 ausgeführt. Dadurch liegt in einem normalen Betriebszustand der Energieversorgungsvorrichtung 10 keine unmittelbare elektrisch leitende Verbindung zu der Masse zweiter Art 18 vor.

Zum Zwecke einer Überwachung eines Isolationswiderstands zwischen der Anschlussvorrichtung 12 und der Masse erster Art 16 weist die Energieversorgungsvorrichtung 10 ein erstes Messgerät 20 auf. Dabei ist das erste Messgerät 20 beispielhaft auf eine dem Fachmann bekannte Weise derart mit der Anschlussvorrichtung 12 verbunden, dass das erste Messgerät 20 in Rahmen einer Selbstdiagnose einen Kontaktverlust einer zugehörigen Messleitung 40 erkennen kann. Bevorzugterweise wird mittels eines Teils der zugehörigen Messleitungen 40 eine Potentialdifferenz zwischen Potentialen der Anschlussvorrichtung 12 erfasst, um auf diese Weise einen Kontaktverlust einer der genannten Messleitungen 40 zu erkennen.

Das in FIG 1 gezeigte Ausführungsbeispiel der Energieversorgungsvorrichtung 10 weist ferner ein weiteres Messgerät 22 auf. Mittels des weiteren Messgeräts 22 wird ein Isolationswiderstand zwischen der Masse erster Art 16 und der Masse zweiter Art 18 erfasst 110. Zu diesem Zweck weist das weitere Messgerät 22 mehrere Messleitungen 24 auf. Mithilfe dieser mehreren Messleitungen 24 des weiteren Messgeräts 22 wird vorliegend beispielhaft der Isolationswiderstand zwischen der Masse erster Art 16 und der Masse zweiter Art 18 erfasst 110.

Zum Zwecke einer Überwachung dieser mehreren Messleitungen 24 im Hinblick auf einen Kontaktverlust ist vorliegend vorgesehen, dass eine erste Messleitung 26 der mehreren Messleitungen 24 elektrisch mit einem ersten Potential 32 einer Energiequelle zweiter Art 30 verbunden wird. Eine weitere Messleitung 28 der mehreren Messleitungen 24 wird mit der Masse zweiter Art 18 verbunden. Auf diese Weise steht ein definierter Potentialdifferenzbereich zur Verfügung, auf Basis dessen das weitere Messgerät 22 im Rahmen einer Selbstdiagnose auf eine dem Fachmann bereits bekannte Weise einen Kontaktverlust an einer der mehreren genannten Messleitungen 24 zuverlässig erkennen kann.

Im vorliegenden Ausführungsbeispiel ist als Energiequelle zweiter Art 30 eine Niedervolt-Energiequelle vorgesehen. Um einen und definierten Potentialdifferenzbereich zum Zwecke einer Überwachung einer Betriebsfähigkeit, der mehreren zu überwachenden Messleitungen 24 des weitere Messgeräts 22 bereitstellen zu können, ist des Weiteren beispielhaft vorgesehen, dass das erste Potential 32 der Energiequelle zweiter Art 30 galvanisch mit dem zweiten Potential 34 dieser Energiequelle zweiter Art 30 verbunden ist. Dies ermöglicht eine zuverlässige Überwachung der mehreren Messleitungen 24 im Hinblick auf einen Kontaktverlust.

In einer bevorzugten Ausführungsvariante ist vorgesehen, dass die weitere Messleitung 28 der mehreren Messleitungen 24 anhand einer elektrisch leitenden Verbindung mit dem zweiten Potential 34 der vorgenannten Energiequelle zweiter Art 30 mit der Masse zweiter Art 18 verbunden ist. Auf diese Weise kann erreicht werden, dass das zweite Potential 34 denselben Wert aufweist wie die Masse zweiter Art 18.

Mittels der vorbeschriebenen Energieversorgungsvorrichtung 10 wird beispielhaft ein Kontaktverlust einer Messleitung der mehreren Messleitungen 24 des weiteren Messgeräts 22 überwacht 100. Zu diesem Zweck sieht das vorliegend beschreibende Beispiel des Verfahrens 100 vor, dass mittels der zu überwachenden Messleitungen 24 ein Ist-Wert einer Potentialdifferenz zwischen dem ersten Potential 32 und dem zweiten Potential 34 der Energiequelle zweiter Art 30 erfasst wird 102. Beispielhaft wird dabei der Ist-Wert der Potentialdifferenz mittels des vorbeschriebenen weiteren Messgeräts 22 ermittelt 104. Auf Basis des derart ermittelten 104 Ist-Werts der Potentialdifferenz sieht das vorliegend beschriebene Beispiel des Verfahrens 100 vor, dass mittels des weiteren Messgeräts 22 ein Wert betreffend eine Abweichung des ermittelten 104 Ist-Werts der Potentialdifferenz von einem vorgebbaren Soll-Wertebereich der Potentialdifferenz ermittelt wird 106. Der Soll-Werteberich ist vorliegend beispielhaft bedingt von einem vorgesehenen Arbeitsbereich der Energiequelle zweiter Art 30. Weiter ist vorliegend vorgesehen, dass eine Information betreffend diese Abweichung ausgegeben wird 108, sobald der ermittelte 106 Wert von einem vorgegebenen Bezugswert abweicht. Ein Kontaktverlust einer der zu überwachenden Messleitungen 24 aufgrund einer Beschädigung oder eines Bruchs ist auf diese Weise rasch und zuverlässig erkennbar.

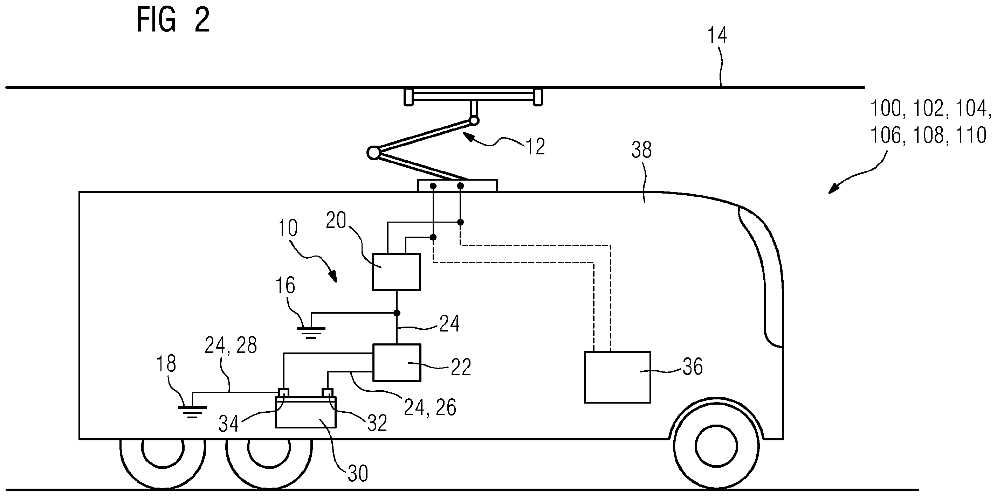

FIG 2 zeigt ein Ausführungsbeispiel eines elektrisch betreibbaren Straßenfahrzeugs 38 in einer schematischen Darstellung. Als Teil dieses Straßenfahrzeugs 38 ist beispielhaft die im Zusammenhang mit FIG 1 beschriebene Energieversorgungsvorrichtung 10 vorgesehen. Zudem illustriert FIG 2 das bereits im Zusammenhang mit FIG 1 beschriebene Beispiel des Verfahrens 100 zur Überwachung eines Kontaktverlusts einer Messleitung der mehreren Messleitungen 24 des weiteren Messgeräts 22.

Mittels der genannten Energieversorgungsvorrichtung 10 ist eine elektrische Energie von der Energiequelle erster Art 14 hin zu einem Verbraucher 36 des Straßenfahrzeugs 38 leitbar. Bei dem elektrischen Verbraucher 36 kann es sich beispielhaft um eine elektrische Antriebsvorrichtung des Straßenfahrzeugs 38 und/oder um einen aufzuladenden Hochvoltenergiespeicher handeln. Auf diese Weise kann die elektrische Antriebsvorrichtung mittels der Energieversorgungsvorrichtung 10 betrieben werden und/oder der Hochvoltenergiespeicher mittels der Energieversorgungsvorrichtung 10 aufgeladen werden. In dem vorliegend beschriebenen Ausführungsbeispiel ist eine Hochvolt-Energiequelle als Energiequelle erster Art 14 vorgesehen. Diese ist beispielhaft als ein Oberleitungssystem dargestellt. Zum Zwecke einer Kopplung der Energieversorgungsvorrichtung 10 mit dem Oberleitungssystem ist als Anschlussvorrichtung 12 beispielhaft einen Stromabnehmer in Form eines Pantographen vorgesehen.

Als Masse zweiter Art 18 ist vorliegend beispielhaft ein metallisches Fahrgestell des Straßenfahrzeugs 38 vorgesehen. Des Weiteren ist als Energiequelle zweiter Art 30 im vorliegend beschriebenen Ausführungsbeispiel eine Niedervolt-Energiequelle vorgesehen. Vorzugsweise ist dabei eine Starterbatterie des Straßenfahrzeugs 38 als die Energiequelle zweiter Art 30 vorgesehen. Auf diese Weise wird mittels der zu überwachenden Messleitungen 24 des weiteren Messgeräts 22 ein Ist-Wert der Potentialdifferenz der Starterbatterie des Straßenfahrzeugs 38 erfasst 102.

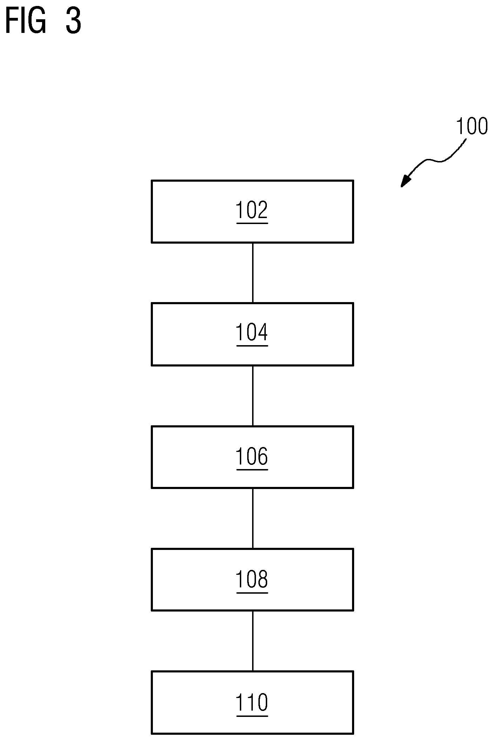

FIG 3 illustriert das im Zusammenhang mit FIG 1 beschriebene Beispiel des Verfahrens 100 schematisch in Form eines Ablaufdiagramms. Dieses schematische Ablaufdiagramm dient gleichfalls zum Zwecke einer Illustration des im Zusammenhang mit FIG 2 beschriebenen Verfahrens 100.

Obwohl die Erfindung im Detail durch die vorgehenden Figurenbeschreibungen näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung gemäß den beigefügten Ansprüchen zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Energieversorgungsvorrichtung (10) aufweisend:
- eine Anschlussvorrichtung (12) zum Zwecke einer elektrischen Verbindung der Energieversorgungsvorrichtung (10) mit einer Energiequelle erster Art (14);
- eine Masse erster Art (16);
- eine Masse zweiter Art (18);
- ein erstes Messgerät (20), welches dazu eingerichtet ist, einen Isolationswiderstand zwischen der Anschlussvorrichtung (12) und der Masse erster Art (16) zu überwachen;
- ein weiteres Messgerät (22), welches dazu eingerichtet ist, einen Isolationswiderstand zwischen der Masse erster Art (16) und der Masse zweiter Art (18) zu überwachen,
**dadurch gekennzeichnet, dass**
das weitere Messgerät (22) eine Energiequelle zweiter Art (30) und mehrere Messleitungen (24) aufweist, von welchen eine erste Messleitung (26) elektrisch mit einem ersten Potential (32) der Energiequelle zweiter Art (30) verbunden ist und von welchen eine weitere Messleitung (28) mit der Masse zweiter Art (18) verbunden ist.

2. Energieversorgungsvorrichtung (10) nach Anspruch 1,
**dadurch gekennzeichnet, dass**
als die Energiequelle erster Art (14) eine Hochvolt-Energiequelle vorgesehen ist.

3. Energieversorgungsvorrichtung (10) nach Anspruch 1 oder 2,
**dadurch gekennzeichnet, dass**
als Energiequelle zweiter Art (30) eine Niedervolt-Energiequelle vorgesehen ist.

4. Energieversorgungsvorrichtung (10) nach einem der vorhergehenden Ansprüche,
**dadurch gekennzeichnet, dass**
ein erstes Potential (32) der Energiequelle zweiter Art (30) galvanisch mit einem zweiten Potential (34) dieser Energiequelle zweiter Art (30) verbunden ist.

5. Energieversorgungsvorrichtung (10) nach einem der vorhergehenden Ansprüche,
**dadurch gekennzeichnet, dass**
als Anschlussvorrichtung (12) ein Stromabnehmer vorgesehen ist.

6. Energieversorgungsvorrichtung (10) nach einem der vorhergehenden Ansprüche,
**dadurch gekennzeichnet, dass**
die weitere Messleitung (28) durch eine elektrisch leitende Verbindung mit dem zweiten Potential (34) der vorgenannten Energiequelle zweiter Art (30) mit der Masse zweiter Art (18) verbunden ist.

7. Fahrzeug (38) mit einer Energieversorgungsvorrichtung (10) nach einem der vorhergehenden Ansprüche und mit einer elektrischen Antriebsvorrichtung (36), welche mittels der genannten Energieversorgungsvorrichtung (10) betreibbar ist.

8. Fahrzeug (38) nach Anspruch 7,
**dadurch gekennzeichnet, dass**
die genannte Energieversorgungsvorrichtung (10) Teil eines Straßenfahrzeugs (38) ist.

9. Fahrzeug (38) nach Anspruch 7 oder 8,
**dadurch gekennzeichnet, dass**
als die Energiequelle zweiter Art (30) eine Starterbatterie des Fahrzeugs (38) vorgesehen ist.

10. Verfahren (100) zur Überwachung eines Kontaktverlusts einer Messleitung der mehreren Messleitungen (24) des weiteren Messgeräts (22) der Energieversorgungsvorrichtung (10) gemäß einem der Ansprüche 1 bis 6,
bei welchem mittels einer der zu überwachenden Messleitungen (28) ein Ist-Wert einer Potentialdifferenz zwischen einem ersten Potential (32) und einem zweiten Potential (34) der Energiequelle zweiter Art (30) der genannten Energieversorgungsvorrichtung (10) erfasst wird (102).

11. Verfahren (100) nach Anspruch 10,
bei welchem der Ist-Wert der Potentialdifferenz zwischen einem ersten Potential (32) und einem zweiten Potential (34) der Energiequelle zweiter Art (30) mittels des weiteren Messgeräts (22) ermittelt wird (104).

12. Verfahren (100) nach einem der Ansprüche 10 bis 11,
bei welchem
- mittels des weiteren Messgeräts (22) ein Wert betreffend eine Abweichung des ermittelten Ist-Werts der Potentialdifferenz von einem vorgebbaren Soll-Wert der Potentialdifferenz ermittelt wird (106);
- eine Information betreffend die genannte Abweichung ausgegeben wird (108), sobald der ermittelte Wert von einem vorgegebenen Bezugswert abweicht.

13. Verfahren (100) nach einem der Ansprüche 10 bis 12,
bei welchem als Energiequelle zweiter Art (30) eine Starterbatterie eines Straßenfahrzeugs (38) vorgesehen wird und mittels der zu überwachenden Messleitung (24) des weiteren Messgeräts (22) ein Ist-Wert einer Potentialdifferenz der Starterbatterie erfasst wird (102).

14. Verfahren (100) nach einem der Ansprüche 10 bis 13,
bei welchem mittels des weiteren Messgeräts (22) ein Isolationswiderstand zwischen der Masse erster Art (16) und der Masse zweiter Art (18) der genannten Energieversorgungsvorrichtung (10) erfasst wird (110).

15. Verfahren (100) nach Anspruch 14,
bei welchem mittels der mehreren zu überwachenden Messleitungen (24) des weiteren Messgeräts (22) der Isolationswiderstand zwischen der Masse erster Art (16) und der Masse zweiter Art (18) der genannten Energieversorgungsvorrichtung (10) erfasst wird (110).

## Claims

1. Energy supply apparatus (10) having:
- a connection apparatus (12) for the purpose of an electrical connection to the energy supply apparatus (10) with a first type of energy source (14);
- a first type of earth (16);
- a second type of earth (18);
- a first measurement device (20), which is configured to monitor an insulation resistance between the connection apparatus (12) and the first type of earth (16);
- a further measurement device (22), which is configured to monitor an insulation resistance between the first type of earth (16) and the second type of earth (18),
**characterised in that**
the further measurement device (22) has a second type of energy source (30) and multiple measurement lines (24), of which a first measurement line (26) is electrically connected to the first potential (32) of the second type of energy source (30) and of which a further measurement line (28) is connected to the second type of earth (18).

2. Energy supply apparatus (10) according to claim 1,
**characterised in that**
a high-voltage energy source is provided as the first type of energy source (14).

3. Energy supply apparatus (10) according to claim 1 or 2,
**characterised in that**
a low-voltage energy source is provided as the second type of energy source (30).

4. Energy supply apparatus (10) according to one of the preceding claims,
**characterised in that**
a first potential (32) of the second type of energy source (30) is galvanically connected to a second potential (34) of said second type of energy source (30).

5. Energy supply apparatus (10) according to one of the preceding claims,
**characterised in that**
a current collector is provided as connection apparatus (12).

6. Energy supply apparatus (10) according to one of the preceding claims,
**characterised in that**
the further measurement line (28) is connected to the second type of earth (18) by way of an electrically conductive connection with the second potential (34) of the previously mentioned second type of energy source (30).

7. Vehicle (38) with an energy supply apparatus (10) according to one of the preceding claims and with an electrical drive apparatus (36), which can be operated by means of the mentioned energy supply apparatus (10).

8. Vehicle (38) according to claim 7,
**characterised in that**
the mentioned energy supply apparatus (10) is part of a road vehicle (38).

9. Vehicle (38) according to claim 7 or 8,
**characterised in that**
a starter battery of the vehicle (38) is provided as the second type of energy source (30).

10. Method (100) for monitoring a loss of contact of a measurement line of the multiple measurement lines (24) of the further measurement device (22) of the energy supply apparatus (10) according to one of claims 1 to 6,
in which an actual value of a potential difference between a first potential (32) and a second potential (34) of the second type of energy source (30) of the mentioned energy supply apparatus (10) is captured (102) by means of one of the measurement lines (28) to be monitored.

11. Method (100) according to claim 10,
in which the actual value of the potential difference between a first potential (32) and a second potential (34) of the second type of energy source (30) is ascertained (104) by means of the further measurement device (22).

12. Method (100) according to one of claims 10 to 11,
in which
- a value relating to a deviation of the ascertained actual value of the potential difference from a specifiable target value of the potential difference is ascertained (106) by means of the further measurement device (22);
- an item of information relating to the mentioned deviation is output (108), as soon as the ascertained value deviates from a specified reference value.

13. Method (100) according to one of claims 10 to 12,
in which a starter battery of a road vehicle (38) is provided as second type of energy source (30) and an actual value of a potential difference of the starter battery is captured (102) by means of the measurement line (24), which is to be monitored, of the further measurement device (22).

14. Method (100) according to one of claims 10 to 13,
in which an insulation resistance between the first type of earth (16) and the second type of earth (18) of the mentioned energy supply apparatus (10) is captured (110) by means of the further measurement device (22).

15. Method (100) according to claim 14,
in which the insulation resistance between the first type (16) of earth and the second type of earth (18) of the mentioned energy supply apparatus (10) is captured (110) by means of the multiple measurement lines (24), which are to be monitored, of the further measurement device (22).

## Revendications

1. Dispositif (10) d'alimentation en énergie comportant :
- un dispositif (12) de connexion afin de connecter électriquement le dispositif (10) d'alimentation en énergie à une source d'énergie d'un premier type (14) ;
- une masse d'un premier type (16) ;
- une masse d'un deuxième type (18) ;
- un premier appareil (20) de mesure, qui est agencé pour contrôler une résistance d'isolation entre le dispositif (12) de connexion et la masse du premier type (16) ;
- un autre appareil (22) de mesure, qui est agencé pour surveiller une résistance d'isolation entre la masse du premier type (16) et la masse du deuxième type (18),
**caractérisé en ce que**
l'autre appareil (22) de mesure a une source d'énergie du deuxième type (30) et plusieurs lignes (24) de mesure, parmi lesquelles une première ligne (26) de mesure est connectée électriquement et raccordée électriquement à un premier potentiel (32) de la source d'énergie du deuxième type (30) et dont une autre ligne (28) de mesure est raccordée à la masse du deuxième type (18).

2. Dispositif (10) d'alimentation en énergie suivant la revendication 1,
**caractérisé en ce qu'**
il est prévu, comme source d'énergie du premier type (14), une source d'énergie de haute tension.

3. Dispositif (10) d'alimentation en énergie suivant la revendication 1 ou 2,
**caractérisé en ce qu'**
il est prévu, comme source d'énergie du deuxième type (30), une source d'énergie à basse tension.

4. Dispositif (10) d'alimentation en énergie suivant l'une des revendications précédentes,
**caractérisé en ce qu'**
un premier potentiel (32) de la source d'énergie du deuxième type (30) est connecté galvaniquement à un deuxième potentiel (34) de cette source d'énergie du deuxième type (30).

5. Dispositif (10) d'alimentation en énergie suivant l'une des revendications précédentes,
**caractérisé en ce qu'**
il est prévu un appareil de prise de courant, comme dispositif (12) de connexion.

6. Dispositif (10) d'alimentation en énergie suivant l'une des revendications précédentes,
**caractérisé en ce que**
l'autre ligne (28) de mesure est raccordée à la masse du deuxième type (18) par une liaison conductrice de l'électricité au deuxième potentiel (34) de la source d'énergie mentionnée ci-dessus du deuxième type (30).

7. Véhicule (38) comprenant un dispositif (10) d'alimentation en énergie suivant l'une des revendications précédentes et comprenant un dispositif (36) d'entraînement électrique, qui peut fonctionner au moyen dudit dispositif (10) d'alimentation en énergie.

8. Véhicule (38) suivant la revendication 7,
**caractérisé en ce que**
ledit dispositif (10) d'alimentation en énergie fait partie d'un véhicule (38) routier.

9. Véhicule (38) suivant la revendication 7 ou 8,
**caractérisé en ce qu'**
il est prévu, comme source d'énergie du deuxième type (30), une batterie de démarreur du véhicule (38).

10. Procédé (100) de surveillance d'une perte de contact d'une ligne de mesure des plusieurs lignes (24) de mesure de l'autre appareil (22) de mesure du dispositif (10) d'alimentation en énergie suivant l'une des revendications 1 à 6,
dans lequel, au moyen de l'une des lignes (28) de mesure à surveiller, on détecte (102) une valeur réelle de différence de potentiel entre un premier potentiel (32) et un deuxième potentiel (34) de la source d'énergie du deuxième type (30) dudit dispositif (10) d'alimentation en énergie.

11. Procédé (100) suivant la revendication 10,
dans lequel on détermine (104), au moyen de l'autre appareil (22) de mesure, la valeur réelle de différence de potentiel entre un premier potentiel (32) et un deuxième potentiel (34) de la source d'énergie du deuxième type (30).

12. Procédé (100) suivant l'une des revendications 10 à 11,
dans lequel
- on détermine (106), au moyen de l'autre appareil (22) de mesure, une valeur concernant un écart de la valeur réelle déterminée de la différence de potentiel à une valeur de consigne pouvant être donnée à l'avance de la différence de potentiel ;
- on donne (108) une information concernant l'écart mentionné, dès que la valeur déterminée s'écarte d'une valeur de référence donnée à l'avance.

13. Procédé (100) suivant l'une des revendications 10 à 12,
dans lequel on prévoit, comme source d'énergie du deuxième type (30), une batterie de démarreur d'un véhicule (38) routier, et on détecte (102), au moyen de la ligne (24) de mesure surveillée de l'autre appareil (22) de mesure, une valeur réelle de différence de potentiel de la batterie de démarreur.

14. Procédé (100) suivant l'une des revendications 10 à 13,
dans lequel, au moyen de l'autre appareil (22) de mesure, on détecte (110) une résistance d'isolation entre la masse du premier type (16) et la masse du deuxième type (18) dudit dispositif (10) d'alimentation en énergie.

15. Procédé (100) suivant la revendication 14,
dans lequel, au moyen des plusieurs lignes (24) de mesure à surveiller de l'autre appareil (22) de mesure, on détecte (110) la résistance d'isolation entre la masse du premier type (16) et la masse du deuxième type (18) dudit dispositif (10) d'alimentation en énergie.
